(19) **Europäisches Patentamt**
**European Patent Office**
**Office européen des brevets**

(11) **EP 4 576 217 A1**

(12) **EUROPEAN PATENT APPLICATION**

(43) Date of publication:
**25.06.2025 Bulletin 2025/26**

(21) Application number: **23219670.9**

(22) Date of filing: **22.12.2023**

(51) International Patent Classification (IPC):
*H01L 27/02* (2006.01)    *H01L 27/06* (2006.01)
*H01L 27/092* (2006.01)    *H10B 10/00* (2023.01)

(52) Cooperative Patent Classification (CPC):
**H10B 10/125; G11C 8/16; G11C 11/412;**
**H10D 84/85; H10D 88/00; H10D 89/10;**
B82Y 10/00; H10D 30/43; H10D 62/121

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **IMEC VZW**
**3001 Leuven (BE)**

(72) Inventors:
• **ABDI, Dawit Burusie**
**3001 Leuven (BE)**
• **BRUNION, Moritz**
**3001 Heverlee (BE)**

(74) Representative: **Lind Edlund Kenamets**
**Intellectual Property AB**
**Kungsportsavenyn 25**
**411 36 Göteborg (SE)**

(54) **SRAM DEVICE**

(57) In an aspect, there is provided an SRAM device comprising:

a plurality of bit cells, each bit-cell comprising a first half cell and a second half cell, each half cell comprising a first and a second CFET device, each CFET device comprising a bottom device and a top device stacked on top of the bottom device,

wherein the first CFET device comprises a common gate shared by the bottom device and the top device and is configured as an inverter cross-coupled to the inverter of the other half-cell,

wherein the bottom device of the second CFET device is configured as a first pass-gate for a first port of the half-cell and comprises a bottom gate coupled to a first word line, and

wherein the top device of the second CFET device is configured as a second pass-gate for a second port of the half-cell and comprises a top gate which is separate from the bottom gate and is coupled to a second word line.

*Fig. 8a*

**Description**

TECHNICAL FIELD

The present invention generally relates to a Static Random Access Memory (SRAM) device.

BACKGROUND

The demand for higher performance two-port SRAM is increasing especially in advanced system on chips (SoCs) such as CPU, GPU applications. Parallel processing is the key for these applications, in which the embedded memories with multi-port types are beneficial as they improve system performance by enabling two processors, threads or processes to simultaneously read/write from/to memory. The 8-transistor (8T) dual-port SRAM bit-cell is able to provide high performance 2 read/write port (2RW) operation, however introduces a significant area overhead, typically about 1.5X larger than the 6T single-port SRAM bit-cell in current technology nodes. Due to the smaller footprint, the 6T single-port bit-cell is the typical choice in current high-density applications.

The Complementary Field-Effect Transistor (CFET) is a transistor device having a complementary pair of FETs, stacked on top of each other (e.g. an NMOS device stacked on top of a PMOS device or vice versa). The CFET allows a reduced footprint compared to a traditional side-by-side arrangement of a pFET and nFET. The two device and contact levels provided by the CFET (e.g. a "2-level middle-of line / MOL") further enables a reduced routing layer usage (e.g. in the back-end-of line / BEOL). The CFET hence facilitates realization of area efficient circuitry.

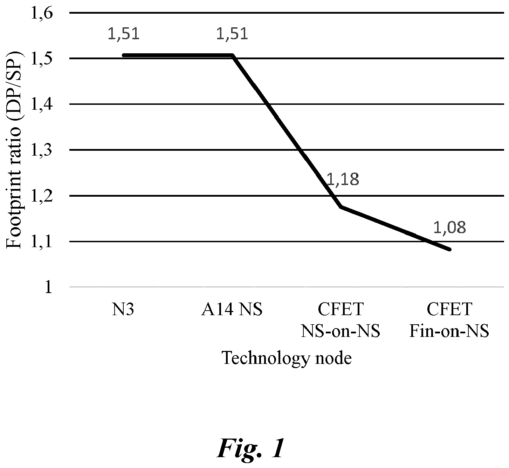

Fig. 1 shows the dual-port to single-port SRAM bit-cell footprint ratio for various technology nodes and device types. Due to the extra two transistors in an 8T bit-cell, the inability to stack devices in non-CFET nodes results in a typical footprint ratio of 1.51. In CFET technology, due to vertically stacking two transistors (e.g., NMOS over PMOS), the footprint ratio of dual-port (8T) to single-port (6T) bit-cells can theoretically be 1. This is because the extra two transistors in the 8T bit-cell can be stacked on the pass-gates of the 6T bit-cell without requiring additional area over the 6T CFET bit-cell. Achieving this theoretical ratio would make the 8T bit-cell the primary choice in designing on-chip memories in modem SoCs, as it offers more functionality than a 6T single-port bit-cell within the same physical footprint. While 6T SRAM bit-cell designs based on stacked complementary transistors pairs have been proposed, there is, according to the knowledge of the inventors, no known proposed circuit design for an 8T dual-port SRAM that is both compatible with the CFET device architecture and enables a small footprint approaching the theoretical dual-port to single-port bit-cell footprint ratio of 1.

SUMMARY

It is thus an object of the present invention to provide a CFET-based 8T SRAM bit cell suitable for a dual-port implementation, which thus enables approaching the theoretical dual-port to single-port bit-cell footprint ratio of 1.

Hence, according to an aspect of the present invention, there is provided an SRAM device comprising:

> a plurality of bit cells, each bit-cell comprising a first half cell and a second half cell, each half cell comprising a first and a second CFET device, each CFET device comprising a bottom device and a top device stacked on top of the bottom device,
> wherein the first CFET device comprises a common gate shared by the bottom device and the top device and is configured as an inverter cross-coupled to the inverter of the other half-cell,
> wherein the bottom device of the second CFET device is configured as a first pass-gate for a first port of the half-cell and comprises a bottom gate coupled to a first word line, and
> wherein the top device of the second CFET device is configured as a second pass-gate for a second port of the half-cell and comprises a top gate which is separate from the bottom gate and is coupled to a second word line.

Thus, the present invention is based on the insight that an 8T bit-cell design that is compatible with the CFET device architecture may be realized based on a bit-cell comprising an equal number of NMOS and PMOS devices. Accordingly, the first pass-gate and the second pass-gate (interchangeably the pass-gate pair) of each half-cell are realized by a CFET device, which means that the first and second pass-gates are complementary devices stacked on top of each other. The bottom device and the top device of the second CFET device (i.e., the first pass-gate and the second pass-gate) may be a PMOS device and an NMOS device, respectively, or vice versa. As the bottom and top gates of the second CFET device are separate, the first pass-gate (the bottom device) and the second pass-gate (the top device) may be individually controlled via the first and second word lines, respectively. The bit-cell design of the SRAM device according to the present aspect is hence an enabler for a high-density, dual port, CFET-based SRAM.

Each CFET device may comprise a first and a second S/D region. The common gate of the first CFET device of the first half-cell and the bottom and top gates of the second CFET device of the second half-cell may be arranged along a first gate track, and the common gate of the first CFET device of the second half-cell and the bottom and top gates of the second CFET device of the first half-cell may be arranged along a second gate track, the first and second gate tracks being parallel to a cell height dimension of the bit-cell.

Further, each CFET device may comprise a first and second S/D region, wherein the S/D regions of the CFET devices of the first half-cell may be arranged along a first active track, and the S/D regions of the CFET devices of the second half-cell may be arranged along a second active track, the first and second active tracks being parallel to a cell width dimension of the bit-cell and transverse to the cell height dimension.

The two inverters (the first CFET devices) may thus be accommodated along only two parallel gate tracks with a layout such that the inverters are located in a first pair of diagonally opposite quadrants of the bit-cell and the two pass-gate pairs are located in a second pair of diagonally opposite quadrants of the bit-cell. This bit-cell layout facilitates interconnect routing within the bit-cell, in particular the cross-coupling between the inverter pairs since the two cross-couplings between the inverters may be routed within the bit-cell without crossing or blocking each other.

In some embodiments, the first half-cell comprises a first common S/D contact arranged between and shared by the first and second CFET devices of the first half-cell, and the second half-cell comprises a second common S/D contact arranged between and shared by the first and second CFET devices of the second half-cell,

> wherein the common S/D contact of the first and second half-cell each comprise a contact extension protruding towards the common S/D contact of the other half-cell (i.e. along the cell-height dimension),
> wherein the common gates of the first CFET devices of the first and second half-cells define first and second common gates, respectively, wherein the first and second common gates each comprise a gate extension protruding towards the second CFET device (i.e. towards the bottom and top gates thereof, and along the cell-height dimension) of the other half-cell,
> wherein the bit-cell comprises:

>> a first local cross-coupling interconnect extending between and interconnecting respective tip portions of the gate extension of the first common gate and the contact extension of the second common S/D contact, and
>> a second local cross-coupling interconnect extending between and interconnecting respective tip portions of the gate extension of the second common gate and the contact extension of the first common S/D contact.

This further facilitates an area-efficient interconnect routing within the bit-cell since the separation (along the cell-height dimension) between the internal storage nodes defined by the inverter of one half-cell and the common gate of the other half-cell may be bridged at least partly by extending the local S/D contacts and the common gates.

In some embodiments, the tip portion of the gate extension of the first common gate is separated from a tip portion of the bottom and top gates of the second CFET device of the second half-cell by a first gate cut region, and wherein the tip portion of the gate extension of the second common gate is separated from a tip portion of the bottom and top gates of the second CFET device of the first half-cell by a second gate cut region.

As per se is known in the art, circuits typically include gate cut regions defined to ensure that a sufficient tip-to-tip separation is provided between gates along a same gate track. Accordingly, by the tip portions of the gate extension and the bottom/top gates along the same gate track being separated by at least a gate cut region, the bit cell layout may provide sufficient process margin with respect to the gate fabrication. The tip portions may for instance be separated by only the gate cut region. This may contribute to a low cell height realization of the bit-cells.

In some embodiments, the first and second local cross-coupling interconnect is configured as a first and second metal strap, respectively, extending along the cell width dimension to bridge a distance between the respective tip portions. The gate extension and contact extension may thus be interconnected by a simple intra-cell metal strap extending transverse thereto.

The first and second metal straps may in particular be arranged on top of the respective tip portions.

In some embodiments, the bottom devices are arranged in a bottom device tier of the bit-cell and the top devices are arranged in a top device tier of the bit-cell,

> wherein the gate extension of the first common gate and the contact extension of the second common S/D contact are arranged in the bottom device tier but not the top device tier, and
> wherein the gate extension of the second common gate and the contact extension of the first common S/D contact are arranged in the top device tier but not the bottom device tier.

Accordingly, the two cross-couplings between the inverters (the first common gate-to-second common S/D contact and the second common gate-to-first common S/D contact) may hence be split between the bottom and device tier. The first and second metal straps may thus be offset along the vertical dimension (i.e., the stacking direction of the devices) such that a need for a spacing along the cell height dimension between the metal straps (which accordingly requires a greater cell height dimension) may be mitigated.

In other words, the gate extension of the first common gate may extend from a bottom gate portion of the first common gate, to protrude relative to a top gate portion of the first common gate. Correspondingly, the contact extension of the second common S/D contact may extend from a bottom contact portion of the second common S/D contact, to protrude relative to a top contact portion of the second common S/D contact. On the other hand, the gate extension of the second common gate may extend from a top gate portion of the second common gate, to protrude relative to a bottom gate portion of the second common gate. Correspondingly, the contact extension of the first common S/D contact may extend from a top contact portion of the first common S/D contact to protrude relative to a bottom contact portion of the first common S/D contact.

The first metal strap may be comprised in a local interconnect layer intermediate the bottom and top device tiers.

The second metal strap may be comprised in a local interconnect layer arranged on top of the top device tier.

The contact extensions may protrude at least to a midline of bit-cell. The common gate of either half-cell need hence only extend a shorter part of the distance to the second CFET device of the other half-cell to facilitate the cross-coupling, which allows a margin to the bottom and top gates of said second CFET device to be increased.

In some embodiments, each bottom device is a nanosheet-FET device (e.g., comprising a channel structure formed by a number of nanosheets) and each top device is a finFET device comprising a channel structure (e.g., a fin-shaped channel structure) with a width dimension (i.e., along the cell-height dimension) smaller than a width dimension of a channel structure of each nanosheet-FET device. The more narrow channel structure of the finFET enables a further cell height reduction.

In some embodiments, the bottom devices are arranged in a bottom device tier of the bit cell and the top devices are arranged in a top device tier of the bit cell,
wherein the gate extensions of the first and second common gates and the contact extensions of the first and second common S/D contacts are arranged in at least the top device tier.

Accordingly, the two cross-couplings between the inverters (the first common gate-to-second common S/D contact and the second common gate-to-first common S/D contact) may hence be provided by metal straps in a common local interconnect layer arranged on top of the top device tiers. This may reduce a complexity of the interconnect routing within the bit cell.

In some embodiments, the first and second pass-gates of the first half-cell are coupled to a first and second bit line, respectively,

the first and second pass-gates of the second half-cell are coupled to a first and second complementary bit line, and
the inverters of the first and second half-cells are coupled to a first power rail and second power rail, one providing a pull-up voltage and the other providing a pull-down voltage.

In embodiments wherein the two inverters (the first CFET devices) are accommodated along only two parallel gate tracks, as set out above, the inverter of the first half-cell may be coupled to a first instance of the first power rail and the inverter of the second half-cell may be coupled to a second instance of the first power rail. The first and second instances of the first power rail may be configured as a respective buried power rail extending along a bottom and top edge of the respective bit cell. The inverters of the first and second half-cells may be coupled to a same (single) instance of the second power rail, wherein the instance of the second power rail may be configured as a buried power rail (BPR) extending along a midline of the respective bit cell. By configuring the power rails as BPRs, routing resources may be freed up for routing bit lines and word lines in the interconnect level above the respective bit cells.

In embodiments wherein the top devices are finFET devices, the instance of the second power rail may be configured as a metal line arranged in a routing track of an interconnect level above the bit cell, wherein the first bit line and the first complementary bit line may be configured as buried signal lines, arranged between the first and second instances of the first power rail. By burying two of the bit lines and shifting the second power rail to the interconnect structure, the number of tracks that need to be routed above the bit cell may be reduced by one. This may further facilitate scaling since the routing tracks may then not limit the cell height reduction enabled by configuring the top devices as finFET devices.

The routing track may be a mid track of a set of routing tracks of the interconnect level and associated with the bit cell, the set of routing tracks extending along the cell width dimension and further comprising: first and second edge tracks overlapping a top and bottom edge of the bit cell, respectively, a first and second off-center track arranged on opposite sides of the mid track, a third off-center track arranged between the first off-center track and the first edge track, and a fourth off-center track arranged between the second off-center track and the second edge track.

A first and second instance of the first word line (WL-A) may be arranged in the first and second edge tracks, respectively.

A first and second instance of the second word line (WL-B) may be arranged in the third and fourth off-center tracks, respectively.

The second bit line and the second complementary bit line may be arranged in the first and second off-center tracks, respectively.

BRIEF DESCRIPTION OF THE DRAWINGS

This and other aspects of the present invention will now be described in more detail, with reference to the appended drawings showing embodiments of the present invention.

Fig. 1 is a diagram showing dual-port (8T) to single-port (6T) bit cell footprint ratios for different device nodes and types.
Fig. 2 is a circuit diagram of a conventional 8T SRAM bit cell with 6 NMOS and 2 PMOS devices.
Fig. 3 is a circuit diagram of an SRAM device comprising a CFET-based 8T SRAM bit-cell with 4 NMOS and 4 PMOS devices according to an implementation.
Fig. 4 is a schematic perspective view of a CFET device.
Fig. 5a-f show cross-sections of various implementations of a CFET device.
Fig. 6a-c shows an SRAM device comprising a bit cell according to an implementation.
Fig. 7a-c shows an SRAM device comprising a bit cell according to a further implementation.
Fig. 8a-c shows an SRAM device comprising a bit cell according to a further implementation.

DETAILED DESCRIPTION

Implementations and examples of SRAM devices and bit cells will below be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a supporting substrate of the memory structure. The term "vertical" refers to a direction parallel to a normal direction of (the main surface of) the substrate, i.e. transverse to the substrate. The first horizontal direction X may in particular correspond to channel direction, or equivalently, a channel or gate length of the CFET devices. In embodiments of bit cells set out below, wherein the X direction may additionally corresponds to a width dimension of a bit cell (meaning that the channel direction of the CFET devices of the bit cells coincides with the width dimension of the bit cell). The second horizontal direction Y may in turn correspond to cell-height dimension of a bit cell.

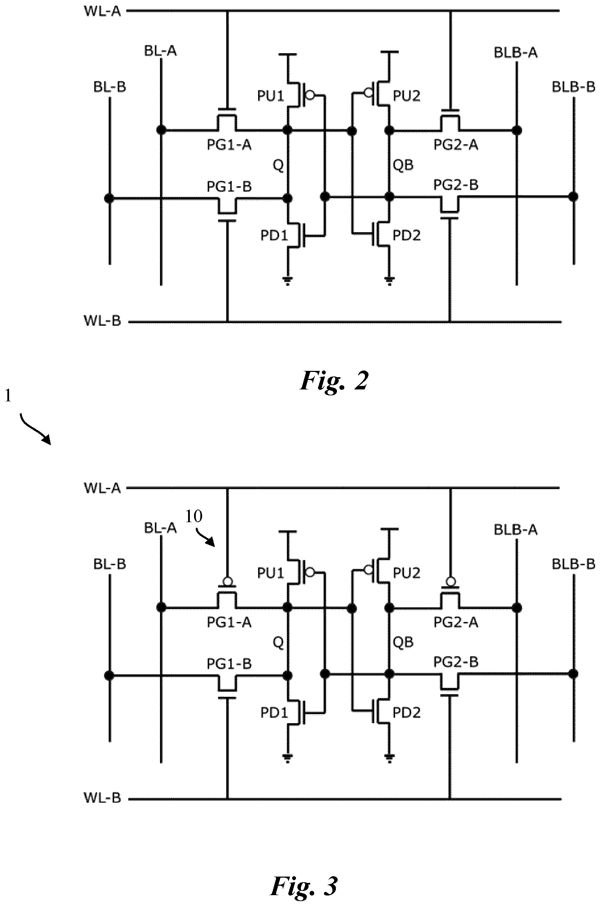

Fig. 2. Is a circuit diagram of a conventional dual 8T SRAM bit cell which may be implemented using conventional non-CFET devices, 6 N-type Metal Oxide Semiconductor Field-Effect Transistor (MOSFET) devices (NMOS) and 2 P-type MOSFET devices (PMOS). The bit cell comprises two cross-coupled inverter pairs, each comprising a PMOS pull-up (PU) device PU1, PU2 and an NMOS pull-down (PD) device PD1, PD2. The bit cell further comprises two NMOS access transistors or pass-gate devices (PG) for each port (Port A: PG1-A, PG2-A and Port B: PG1-B, PG2-B). Since the PG devices of each port are independently connected to their respective word lines (WL-A, WL-B) and bit lines (BL-A, BLB-A, BL-B, BLB-B), the storage nodes Q, QB formed by the cross-coupled inverters can be accessed simultaneously by the two ports.

In the conventional non-CFET device 8T SRAM bit cell as shown in Fig. 2, there would be no benefit to the bit cell footprint from switching the access NMOS transistor to PMOS, having an NMOS access transistor for port A and a PMOS access transistor for port B, or vice versa. Meanwhile, as realized by the inventors, for CFET devices, the conventional approach (i.e., 6 NMOS + 2 PMOS devices or 6 PMOS + 2 NMOS devices) would not be effective as it would result in a larger CFET 8T bit cell footprint.

Therefore, according to the present disclosure, there is provided a CFET-based 8T bit cell with an equal number of NMOS and PMOS devices (4 NMOS and 4 PMOS devices), a circuit layout of which is shown in Fig. 3. As shown in Fig. 3, the access transistors for ports A and B are PMOS (PG1-A and PG2-A) and NMOS (PG1-B and PG2-B) devices, respectively. This allows the proposed bit cell to more efficiently utilize the CFET device architecture, thereby enabling a small CFET 8T bit cell layout. This may be appreciated more fully in view of the following.

As used herein, the term "CFET" device refers to a device comprising a bottom FET device of a first conductivity type and a top FET device of a second conductive type opposite the first conductivity type stacked on top of the bottom FET device, e.g. an NMOS top device stacked on top of a PMOS bottom device, or vice versa. For conciseness the bottom FET device and the top FET device may interchangeably be referred to as a bottom device and a top device, respectively.

A CFET device may be provided in a split gate configuration with separate (i.e. disconnected) gates for the bottom device and the top device. That is, a CFET device with a split gate configuration comprises a bottom gate for the bottom device and a top gate for the top device being separate from the bottom gate. A CFET device may also be provided in a common gate configuration with a common gate shared by the bottom and top devices. That is, a CFET device with a common gate configuration comprises a common gate shared by the bottom and top devices. The common gate may thus comprise a bottom gate portion for the bottom device and a top gate portion for the top device coupled to the bottom gate portion.

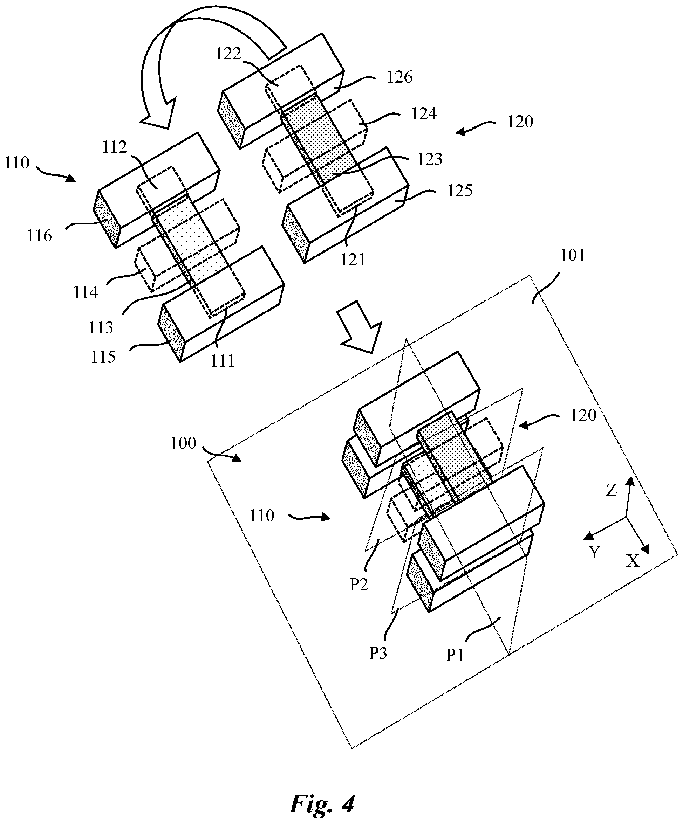

Fig. 4 is a schematic perspective view of a CFET device 100 comprising a bottom device 110 and a top device 120 stacked on top of the bottom device 110. The bottom device 110 defines a bottom level or bottom tier of the CFET device 100 and the top device 120 defines a top level or top tier of the CFET device 100. The bottom device 110 may be a PMOS device and the top device 120 may be an NMOS device, or vice versa.

The CFET device 100 is arranged on a substrate, schematically indicated by reference sign 101. The substrate 101 may be of a conventional type suitable for CMOS devices, for instance a bulk substrate of a semiconductor such as Si or SiGe, or a silicon-on-insulator (SOI) substrate, to give a few non-limiting examples.

The bottom device 110 comprises a first source/drain (S/D) region 111, a second S/D region 112, a channel structure 113 extending between the first S/D region 111 and the second S/D region 112, and a gate 114 surrounding the channel structure 113. The top device 120 comprises a first S/D region 121, a second S/D region 122, a channel structure 123 extending between the first S/D region 121 and the second S/D region 122, and a gate 124 surrounding the channel structure 114. The labels "bottom" and "top" may in the following be used to refer to an element of, or associated with, the bottom device 110 and the top device 120, respectively, such as first S/D regions 111/121, the second S/D regions 112/122, the channel structures 113/123, the gates 114/124, etc.

The top device 120 is stacked on top of the bottom device 110 such that the first top S/D region 121 overlaps the first bottom S/D region 111, the second top S/D region 122 overlaps the second bottom S/D region 112, and the top channel structure 123 overlaps the bottom channel structure 113. The "overlap" here refers to an overlap as seen along the vertical direction Z. Accordingly, as shown in Fig. 4, the first S/D regions 111/121, the second S/D regions 112/122 and the channel structures 113/123 intersect a common (geometrical) vertical plane P1 (parallel to the XZ-plane).

A respective S/D contact 115, 116, 125 and 126 may as shown be arranged on each of the first bottom S/D region 111, the second bottom S/D 112, the first top S/D region 121 and the second top S/D region 122, respectively. Analogous to the first S/D regions 111/121 and the second S/D regions 112/122, the first top S/D contact 125 may overlap the first bottom S/D contact 115 and the second top S/D contact 125 may overlap the second bottom S/D contact 115.

In Fig. 4, the channel structures 113, 123 are merely schematically shown but may typically comprise a number of (i.e., one or more) channel nanosheets. The CFET device 100 may hence comprise a bottom nanosheet FET (NSHFET) 110 and a top NSHFET 120. In an alternative CFET design, the channel structure 113 of the bottom device 110 may comprise a number of channel nanosheets and the channel structure 123 of the top device 120 may comprise a semiconductor fin (i.e., a fin-shaped channel structure). The CFET device 100 may hence comprise a bottom nanosheet NSHFET 110 and a top FinFET 120.

The bottom gate 114 may surround the bottom channel structure 113, partly (such as on three-sides) or completely to define a gate-all-around (GAA) for one or more channel nanosheets of the bottom channel structure 113. The top gate 124 may surround the top channel structure 123, partly (such as on three-sides) or completely to define a gate-all-around (GAA) for one or more channel nanosheets of the top channel structure 123.

The channel structures 113, 123 comprise a semiconductor material such as a group IV semiconductor, e.g. Si, Ge, or SiGe. However also other materials are possible such as group III-V semiconductors (e.g. InP, InAs, GaAs, GaN).

The S/D regions 111, 112, 121, 122 may comprise or be formed by epitaxial S/D bodies. The epitaxial S/D bodies may comprise doped semiconductor material (e.g. Si, Ge, SiGe), e.g. epitaxially grown on the channel structures 113, 123. The S/D regions 111, 112, 121, 122 may alternatively be formed by doped portions of the channel structures 113, 123.

The S/D contacts 115, 116, 125, 126 may comprise one or more contact metals such as W, Al, Ru, Mo or Co, and optionally conventional barrier metals such as Ta, TiN or TaN.

The gates 114, 124 may comprise one or more gate metal layers, such as one or more work function metal (WFM) layers and/or a gate fill layer. Example WFMs include conventional n-type and p-type effect WFMs, such as TiN, TaN, TiAl, TiAlC or WCN, or combinations thereof. Example fill metals include W and Al. A gate dielectric layer (not shown) is provided between the gates 114, 124 and the respective channel structures 113, 123. Example gate dielectrics include conventional gate dielectrics, e.g., a high-k dielectric such as $HfO_2$, LaO, AlO or ZrO.

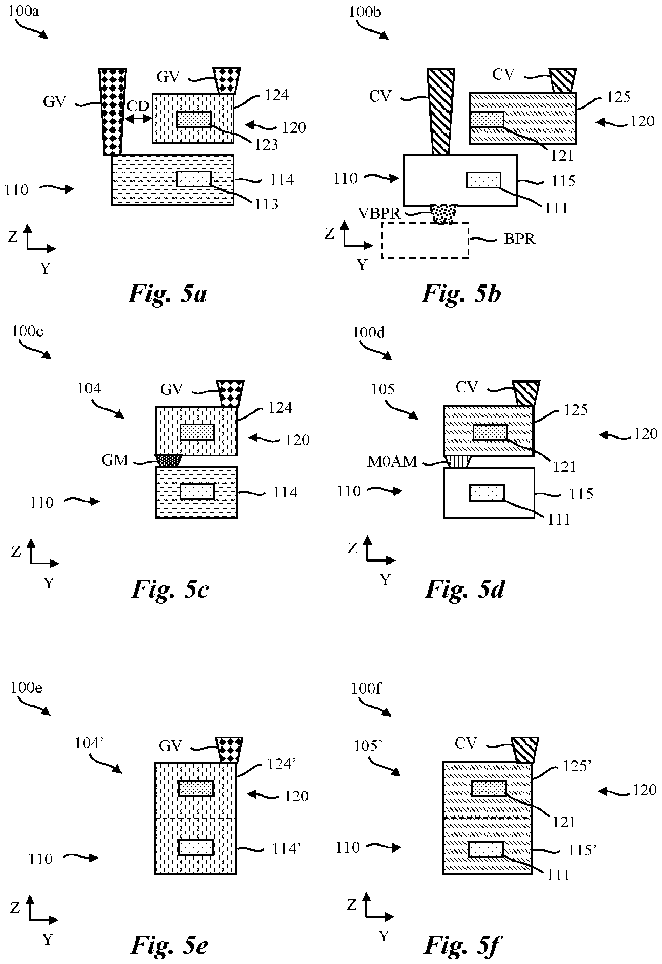

The CFET device 100 as shown in Fig. 4 has a split gate configuration as well as separate (i.e., disconnected) first S/D contacts 115, 125 and separate second S/D contacts 116, 126. There are however numerous further configurations of a CFET device, as now will be discussed with reference to Fig. 5a-f. Fig. 5a, c, e each show a cross-section of a respective configuration of a CFET device taken across the channel structures 113, 123 and along the gates 114, 124, i.e., along plane P2 indicated in Fig. 4. Meanwhile, Fig. 5b, d, f each show a cross-section of a respective configuration of a CFET device taken across the sources 111, 121 and the contacts 115, 125, i.e., along plane P3 indicated in Fig. 4. Although Fig. 5b, d, f shows cross-sections at the side of first S/D regions of CFET devices, the configurations shown in these figures may be applied in a corresponding manner to second opposite S/D regions of the CFET devices.

Fig. 5a shows a CFET device 100a having a split gate configuration with separate bottom and top gates 114, 124. The bottom gate 114 comprises as shown a side gate portion or gate extension protruding outside the top gate 124 to define a landing portion for a gate via GV. The gate extension extends laterally with respect to the channel structures 113, 123, i.e.,

along the Y-direction. The dimension or extent of the gate extension may vary in accordance with the available space adjacent the CFET device 100a in a given circuit implementation. However, the minimum extension of the gate extension is determined by the critical dimension (CD) indicated in Fig. 5a, which corresponds to the minimum separation between the GV and the top gate 124. The top gate 124 may as shown be contacted by a separate GV.

Fig. 5b shows a CFET device 100b comprising separate first S/D contacts 115, 125, wherein the bottom contact 115 comprises a side contact portion or contact extension protruding outside the top contact 125 to define a landing portion for a contact via CV. The contact extension extends laterally with respect to the channel structures 113, 123, i.e., along the Y-direction. The dimension or extent of the contact extension may vary in accordance with the available space adjacent the CFET device 100b. However, the minimum extension of the contact extension is determined by the CD indicated in Fig. 5b, which corresponds to the minimum separation between the CV and the top contact 125. The top contact 125 may as shown be contacted by a separate CV.

Fig. 5b further shows an alternative contact scheme for the bottom contact 115 wherein the bottom contact 115 is contacted from a backside of the substrate or device by a via-to-BPR (VBPR), also called power via (PV). The VBPR may in turn be connected to a backside, or buried, power rail (BPR). The term BPR is here used in an inclusive sense to refer to a power rail regardless of whether it is formed in a trench embedded in a substrate at the front end of line, or as part of a backside power distribution network (PDN) formed on the backside of the substrate at the back end of line.

Fig. 5c shows a CFET device 100c having a common gate configuration, thus comprising a common gate 104 shared by the bottom and top device 110, 120. The common gate 104 comprises a bottom gate portion 114 and a top gate portion 124 coupled to the bottom gate portion 114 by a gate merge via GM. The gate merge via is arranged intermediate the bottom gate portion 114 and the top gate portion 124 and extends therebetween (i.e., vertically along the Z-direction) to interconnect the gate portions 114 and 124. The common gate may be as shown be contacted by a GV landing on the top gate portion 124.

Fig. 5d shows a CFET device 100d comprising a common S/D contact 105 shared by the bottom and top device 110, 120, more specifically by the first bottom and top S/D regions 111, 121. The common S/D contact 105 comprises a bottom contact portion 115 and a top contact portion 125 coupled to the bottom contact portion 115 by a contact merge via M0AM (where M0A denotes the local interconnect level of the CFET device 100d). The contact merge via is arranged intermediate the bottom contact portion 115 and the top contact portion 125 and extends therebetween (i.e., vertically along the Z-direction) to interconnect the contact portions 115 and 125. The bottom contact portion 115 is arranged on (e.g., surrounds) the bottom source 111 and the top contact portion 125 is arranged on (e.g., surrounds) the top source 121. The common contact 105 may as shown be contacted by a CV landing on the top contact portion 125. While not shown in Fig. 5d, it is also possible to contact the common contact from the backside, e.g., in an analogous manner to Fig. 5b.

Fig. 5e shows a CFET device 100e comprising a common gate 104' comprising a bottom gate portion 114' and a top gate portion 124'. The bottom gate portion 114' and the top gate portion 124' form part of the continuous common gate 104' (e.g., being an integrally formed gate body). Fig. 5e hence shows a further example of a CFET device 100e comprising a common gate shared by the bottom device 110 and the top device 120. As shown in Fig. 5e, the bottom gate portion 114' corresponds to the portion of the common gate 104' surrounding the channel structure of the bottom device 110 and the top gate portion 124' corresponds to the portion of the common gate 104' surrounding the channel structure of the top device 120. The common gate may as shown be contacted by a GV landing on the top gate 124. While Fig. 5e shows a same fill pattern for the bottom and top gates 114, 124 it is also possible to form the bottom and top gate portions 114, 124 of different compositions, using appropriate process techniques (e.g., a "split-RMG" CFET process).

Fig. 5f shows a CFET device 100f comprising a common S/D contact 105' comprising a bottom contact portion 115' and a top contact portion 125'. The bottom and top contacts 115, 125 form part of the continuous common contact 105' (e.g., being an integrally formed contact body). Fig. 5f hence shows a further example of a CFET device 100f comprising a common S/D contact 105' shared by the bottom device 110 and the top device 120. As shown in Fig. 5f, the bottom contact portion 115' corresponds to the portion of the common contact 105' arranged on (e.g., surrounding) the bottom source 111 and the top contact portion 125' corresponds to the portion of the common contact 105' arranged on (e.g., surrounding) the top source 121. The common S/D contact 105' may as shown be contacted by a CV landing on the top contact portion 125. While Fig. 5f shows a same fill pattern for the bottom and top contact portions 115', 125' it is also possible to form the bottom and top contact portions 115', 125' of different compositions, using appropriate process techniques.

The split gate configuration shown in Fig. 5a may for instance be obtained using the "sequential CFET process". As per se is known in the art, in the sequential CFET process the bottom and top devices are formed sequentially, and results in a split bottom and top gates.

The common gate configuration of Fig. 5c may be achieved by supplementing the standard sequential CFET process with additional process steps to form the gate merge via GM for interconnecting the bottom and top gate portions. The common gate configuration shown in Fig. 5e may be be obtained using the "monolithic CFET process" As per se is known in the art, in the monolithic CFET process the bottom and top devices are processed in parallel, top-down. While the standard monolithic CFET process results in a common gate configuration, it may be supplemented with additional process steps to enable a split gate configuration for selected CFET devices (e.g. bottom gate recess, bottom gate capping, followed by top gate formation).

Common or separate source or drain contacts may be formed using conventional CFET device processing techniques. For instance, separate (first or second) S/D contacts may be formed by depositing contact metal on the (first or second) S/D regions, etching back the contact metal to a level below the (first or second) top S/D region, capping the remaining contact metal on the (first or second) bottom S/D region with an insulating layer and subsequently depositing contact metal on the (first or second) top S/D.

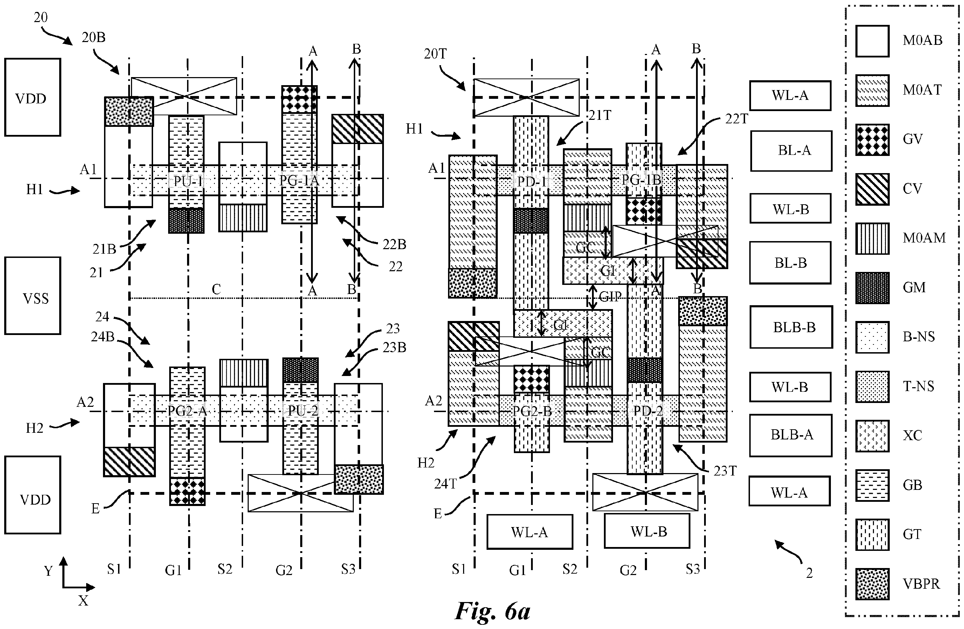

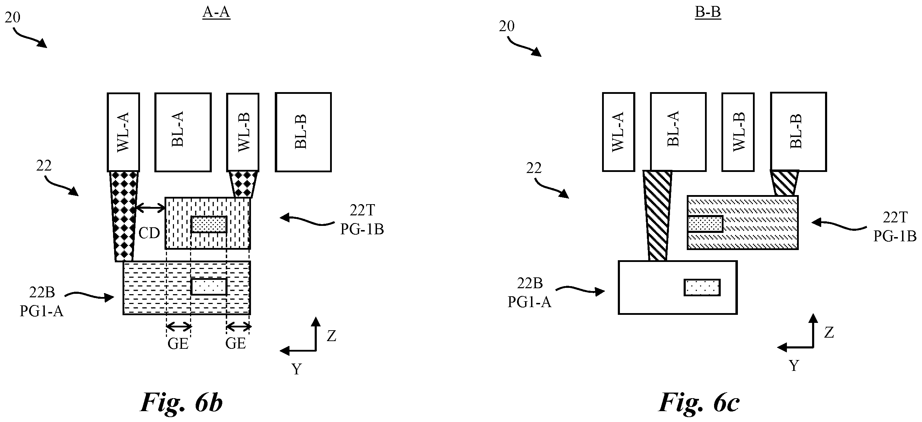

Various example implementations of SRAM devices with CFET-based 8T dual-port bit cells will now be described with reference to Fig. 6a-c, 7a-c and 8a-c. A common feature is that the bit cells comprise a first half cell H1 and a second half cell H2, each half cell comprising a first and a second CFET device, wherein the first CFET device comprises a common gate shared by its bottom and top device and is configured as an inverter cross-coupled to the inverter of the other half-cell (corresponding to the cross-coupled inverter pairs PU1-PD1 and PU2-PD2 in Fig. 3). Further, the bottom device of the second CFET device of each half-cell is configured as a first pass-gate (corresponding to PG1-A and PG2-A in Fig. 3) for a first port of the respective half-cell (corresponding to BL-A and BLB-A in Fig. 3) and comprises a bottom gate coupled to a first word line (corresponding to WL-A of Fig. 3). Further, the top device of the second CFET device of each half-cell is configured as a second pass-gate (corresponding to PG1-B and PG2-B in Fig. 3) for a second port of the respective half-cell (corresponding to BL-B and BLB-B in Fig. 3) and comprises a top gate which is separate from the bottom gate and is coupled to a second word line (corresponding to WL-B in Fig. 3). The respective bit cell designs will described in further detail in the following.

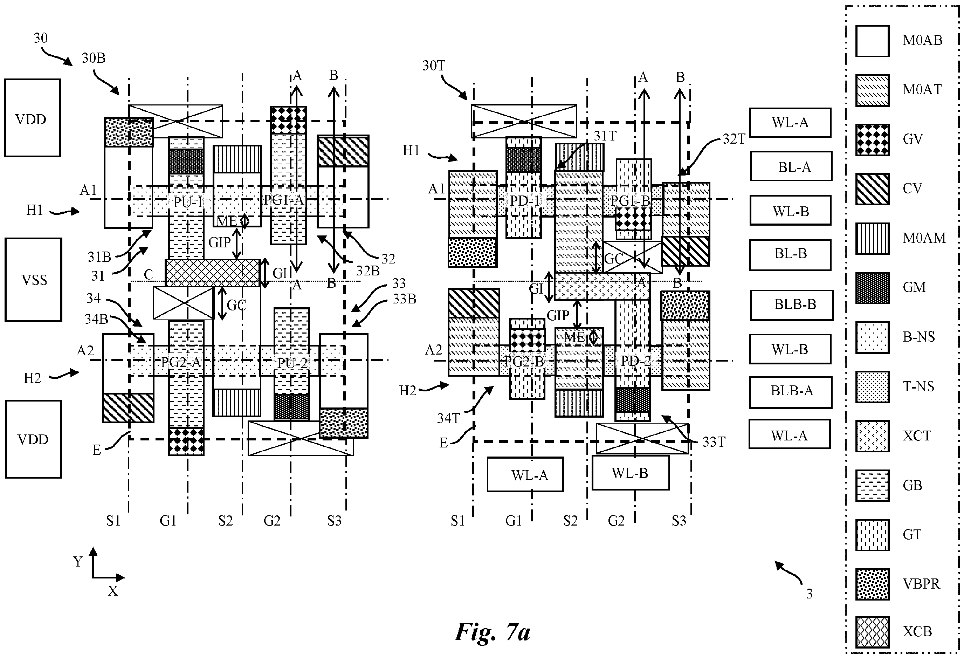

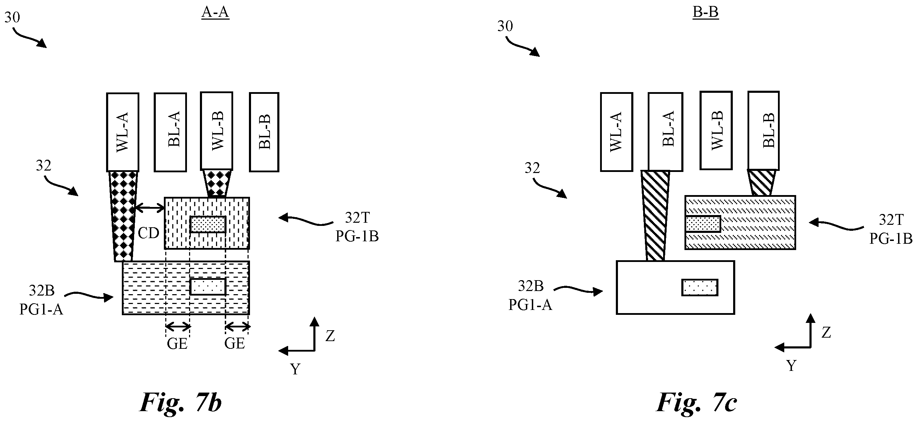

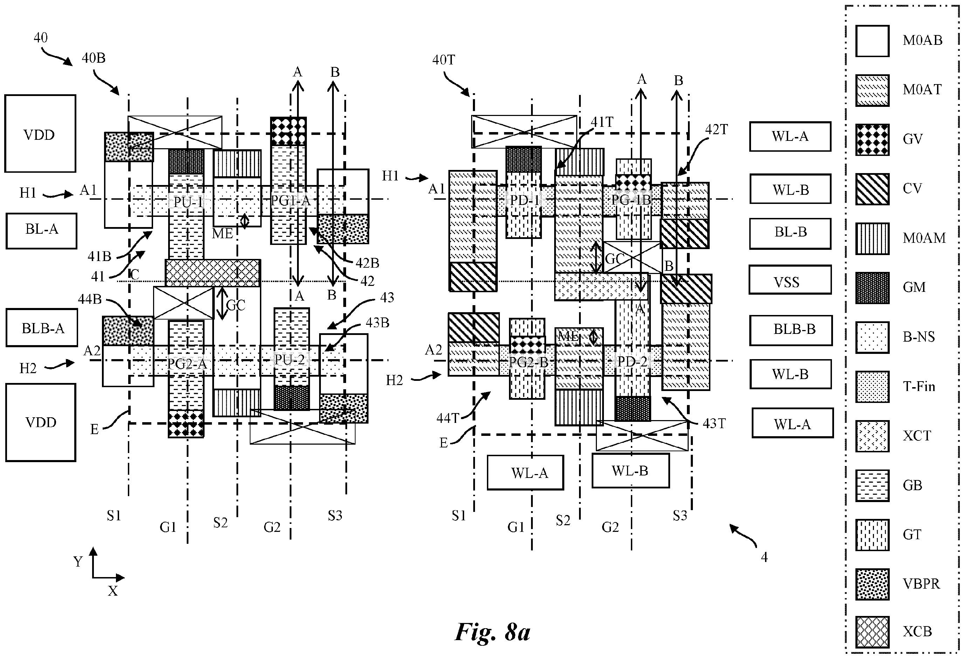

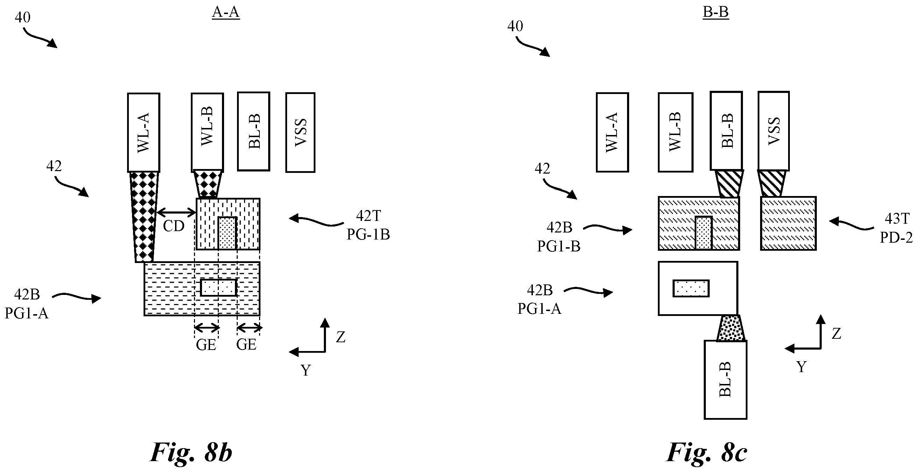

In Fig. 6a, the first and second CFET device of the first half-cell H1 and the second half-cell H2 have reference signs 21 and 22, and 23 and 24, respectively. In Fig. 7a, the first and second CFET device of the first half-cell H1 and the second half-cell H2 have reference signs 31 and 32, and 33 and 34, respectively. In Fig. 8a, the first and second CFET device of the first half-cell H1 and the second half-cell H2 have reference signs 41 and 42, and 43 and 44, respectively.

Further, the reference signs and labels in the figures have the following common meaning:
Reference sign E indicates the edges of a bit cell. Reference signs H1 and H2 indicate first and second half-cells of a bit cell. Direction X indicates a cell width dimension and, equivalently, a channel direction for the CFETs of the bit cell, and direction Y indicates a cell height dimension. Lines A1 and A2 indicate first and second active tracks of a bit cell extending in parallel in the cell width dimension X. Lines G1 and G2 indicate first and second gate tracks of a bit cell extending in parallel in the cell height dimension Y. Lines S1-S3 indicate respective S/D contact tracks extending in parallel in the cell height dimension Y, wherein the first and third S/D contact tracks S1, S3 extend along opposite edges of the bit cell and the second S/D contact track S3 extends midway between G1 and G2. Crossed out rectangular regions indicate gate cut regions (GC).

The fill patterns used in the figures have the following meaning:
"MOAB" is the local interconnect level of the bottom tier. Hence, a feature with the fill pattern associated with "MOAB" is a contact located in located in the bottom tier (e.g. a bottom S/D contact). MOAT is the local interconnect level of the top tier. Hence, a feature with the fill pattern associated with MOAT is a contact located in the top tier (typically a top S/D contact). MOAB and MOAT are each comprised in the local interconnect level "M0A" of the bit cell.

The fill pattern associated with "GV" is used to indicate a gate via extending between a bottom gate/bottom gate portion ("GB") and an upper interconnect level, or a top gate/top gate portion ("GT"), e.g. as shown in Fig. 5a. The upper interconnect level may be the first interconnect level above the local interconnect level M0A (sometimes denoted "M0" or "MINT", depending on context).

The fill pattern associated with "CV" indicates a contact via extending between MOAB or MOAT and an upper interconnect level, e.g. as shown in Figi. 5b. Like for the gate via GV, the upper interconnect level may be the first interconnect level above the local interconnect level M0A (e.g. M0).

The fill pattern associated with "M0AM" is a local interconnect merge layer or via, interconnecting a contact in M0AB with a contact in MOAT, e.g. as shown in Fig. 5d.

The fill pattern associated with "GM" indicates a gate merge layer or via, interconnecting a bottom gate or bottom gate portion (GB) with a top gate or top gate portion (GT), e.g. as shown in Fig. 5c.

The fill pattern associated with "B-NS" indicates a nanosheet or nanosheet stack in the bottom tier B. The fill pattern associated with "T-NS" indicates a nanosheet or nanosheet stack in the top tier T. The fill pattern associated with "T-Fin" indicates a fin or a fin-shaped channel structure in the top tier T.

The fill pattern associated with "XC" indicates a cross-couple merge layer or metal strap formed on top of the MOAT and comprised in the local interconnect level M0A. It may also be referred to as a gate-spacer merge layer as it may be arranged to extend over and across a gate spacer to merge or interconnect a gate with a S/D contact in MOAT.

The fill pattern associated with "VBPR" indicates a via-to-BPR. In instances where a VBPR is shown over a contact in MOAT, it is to be understood that there is a further via extending from MOAT through the local interconnect level MOAB and landing on the VBPR.

The rectangular boxes on the left-hand side of the bit cell in Fig. 6a, 7a and 8a indicate instances of BPRs extending in parallel in the Y-direction underneath the bit cell.

The rectangular boxes on the right-hand side of the bit cell indicate routing tracks in a first interconnect level above the local interconnect level M0A (e.g. M0) extending in parallel in the Y-direction, within the footprint of the bit cell. As is known to the skilled person, a metal line (e.g. word line or bit line) arranged in any given routing track in the first interconnect level (or second interconnect level) need not extend along the full width dimension (or full height dimension) of the bit cell but should at least extend so as to define an overlap with any contact via CV, gate via GV arranged along the routing track, so as to enable a coupling between the metal line and the underlying contact or gate.

The rectangular boxes below the bit cell indicate routing tracks in a second interconnect level above the first interconnect level (e.g. M1). Metal lines arranged in any given routing track in the second interconnect level may be coupled to a metal line in a correspondingly labeled routing track in the first interconnect level (e.g. by a via in M1).

Figure 6a-c shows an SRAM device 2 comprising a CFET-based dual-port 8T bit cell according to a first design.

The S/D regions, S/D contacts and gates of the first CFET device 21 and the second CFET device 22 of the first half-cell H1 are as shown arranged along a first active track A1. Correspondingly, the S/D regions, S/D contacts and gates of the first CFET device 23 and the second CFET device 24 of the second half-cell H2 are arranged along a second active track A2. Further, the common gate of the first CFET device 21 of the first half-cell H1 and the split bottom and top gates of the second CFET device 24 of the second half-cell H2 are arranged along a first gate track G1, and the common gate of the first CFET device 23 of the second half-cell H2 and the split bottom and top gates of the second CFET device 22 of the first half-cell H1 are arranged along a second gate track G2.

Each bottom device 21B, 22B, 23B, 24B and each top device 21T, 22T, 23T, 24T of the CFET devices 21, 22, 23, 24 comprises a first S/D region and a second S/D region. The first S/D regions of the CFET devices 21, and 24 are arranged along the first S/D contact track S1. The first S/D regions of the CFET devices 22, and 23 are arranged along the third S/D contact track S3. The second S/D regions of the CFET devices 21, 22, 23, 24 are arranged along the second S/D contact track S2.

The first half-cell H1 comprises a first common S/D contact arranged between the first and second CFET 21, 22 of the first half-cell H1 and shared by their respective second S/D regions. The second half-cell H2 comprises a second common S/D contact arranged between the first and second CFET devices 23, 24 of the second half-cell H2 and shared by their respective second S/D regions. The first and second common S/D contacts are arranged along the second S/D contact track S2.

The first S/D regions of each CFET device 21, 22, 23, 24 are each coupled to respective S/D contacts which are split between the bottom and top tiers 20B, 20T. The first S/D regions of the bottom and top devices of the CFET devices 21, 22, 23, 24 are hence individually contacted. The S/D contacts coupled to the first S/D regions of the first CFET device 21 of the first half-cell H1 and the first S/D regions of the second CFET device 24 of the second half-cell H2 are arranged along the first S/D contact track S1. The S/D contacts coupled to the first S/D regions of the second CFET device 22 of the first half-cell H1 and the first S/D regions of the first CFET device 23 of the second half-cell H2 are arranged along the third S/D contact track S3.

As per the illustrated example, the bottom tier 20B and top tier 20T, respectively, comprise the four PMOS devices (PU-1, PU-2, PG1-A, and PG2-A) and four NMOS devices (PD-1, PD-2, PG1-B and PG2-B).

The two inverters are created by merging the drains of PU-1 (PU-2) and PD-1 (PD-2) of the first CFET device 21 (and 23) using the M0A merge layer M0AM and their top and bottom gates using the gate merge layer GM.

The gate-spacer merge layer XC on the top tier 20T is used to enable the inverter cross-coupling. More specifically, the first and second common S/D contacts each comprises, as shown, a respective contact extension protruding along the cell-height dimension X towards the other common S/D contact. Further, the common gates of the first CFET devices 21, 23 each comprise a gate extension protruding towards the (split) gates of the second CFET devices 22, 24 of the opposite half-cell H1, H2.

The gate extension of the common gate of first CFET device 21 of the first half-cell H1 protrudes such that its tip portion is separated from a tip portion of the bottom and top gates of the second CFET device 24 of the second half-cell H2 by a first gate cut region GC. Correspondingly, the gate extension of the common gate of the first CFET device 23 of the second half-cell H2 may protrude such that its tip portion is separated from a tip portion of the bottom and top gates of the second CFET device 22 of the first half-cell H1 by a second gate cut region GC.

A first metal strap XC extends in the Y-direction to bridge a distance between, and thus interconnect the respective tip portions of the gate extension of the common gate of the first CFET device 21 of the first half-cell H1 and the contact extension of the second common S/D contact of the second half-cell H2. Correspondingly, a second metal strap XC extends in the Y-direction to bridge the distance between, and thus interconnect the respective tip portions of the gate extension of the common gate of the first CFET device 23 of the second half-cell H2 and the contact extension of the first common S/D contact of the first half-cell H1.

The PMOS pass gates for port A (PG1-A and PG2-A) are arranged in the bottom tier 20B underneath the NMOS pass gates for port B (PG1-B and PG2-B). The pass gates for port A and port B can be controlled independently as the top and bottom gates of the respective second CFETs 22 and 24 are split.

The layout of the bottom tier 20B and the cross-sectional view of Fig. 6b (taken along A-A) of Fig. 6a demonstrate the split-gate configuration of the stacked pass gates PG1-A, PG1-B, the minimum gate extension GE, and the requirement for 1CD (critical dimension) spacing from the top gate TG to the gate via GV to the bottom gate BG for connecting to WL-A.

The SRAM device 2 comprises as shown two instances of a pull-up power rail ("first power rail") VDD configured as BPRs extending in the cell width dimension X along opposite edges of the bit cell 20. The pull-up devices PU-1 and PU-2 are coupled to respective instances of the pull-up power rail VDD by a respective VBPR.

The SRAM device 2 further comprises an instance of a pull-down power rail ("second power fail") VSS, also configured as a BPR and extending in the cell width dimension X along a midline C of the bit cell 20. The pull-down devices PD-1 and PD-2 are coupled to instance of the pull-down power rail VSS by a respective VBPR.

The bit cell interconnections are otherwise as follows:

The bit cell 20 is associated with eight routing tracks, each comprising a respective instance of a first or second word line WL-A, WL-B, first or second bit lines BL-A, BL-B, or first or second complementary bit lines BLB-A, BLB-B. The first and second instances of the first word line WL-A may as shown be arranged in respective edge tracks, overlapping the top and bottom edges of the bit cell 20. This allows the instances of the first word lines WL-A to be shared with neighboring bit cells.

The split bottom and top S/D contacts (in MOAB and MOAT, respectively) of the first and second pass-gates PG1-A, PG1-B of the first half-cell H1 are coupled to a first and second bit line BL-A, BL-B, respectively, (arranged in M0) by a respective contact via CV. The contact vias are as shown arranged at opposite lateral sides of the first active track A1.

The split bottom and top gates "B an' GT of the first and second pass-gates PG1-A, PG1-B of the first half-cell H1 are coupled to a first instance of a first word line WL-A and a first instance of a second word line WL-B, respectively, (arranged in M0) by a respective gate via GV. The gate vias are as shown arranged at opposite lateral sides of the first active track A1.

The split bottom and top S/D contacts (in MOAB and MOAT, respectively) of the first and second pass-gates PG2-A, PG2-B of the second half-cell H2 are coupled to a first and second complementary bit line BLB-A, BLB-B, respectively, (arranged in M0) by a respective contact via CV. The contact vias are as shown arranged at opposite lateral sides of the second active track A2.

The split bottom and top gates GB and GT of the first and second pass-gates PG2-A, PG2-B of the second half-cell H2 are coupled to a second instance of the first word line WL-A and a second instance of the second word line WL-B, respectively, (arranged in M0) by a respective gate via GV. The gate vias are as shown arranged at opposite lateral sides of the second active track A2.

As may be appreciated from Fig. 6a-c, the bit cell height along the bit cell height dimension X is determined by the minimum gate-cut (GC), the minimum gate extension (GE), the nanosheet width (NSHW), the minimum gate internal spacer merge width (GI), the minimum space between the gate spacer merge layers (GIP), and the CD requirement for the gate via to the bottom gate. As an illustrative example, for a state of the art technology node, the total cell height becomes 136 nm:

$$\text{Cell height} = 2^*GC + 4^*GE + 2^*NSHW + 2^*GI + GIP + 3^*CD = 2^*12 + 4^*9 + 2^*11 + 2^*9 + 9 + 3^*9 = 136 \text{ nm (eq. 1)}$$

As may be appreciated, the parameter values in eq. 1 should only be considered as representative examples. However, the form of eq. 1 is of course applicable also for other values of the various parameters.

As shown in Fig. 6a-c, most of the signal routing and integration are enabled in the top tier 20T leaving the bottom tier 20B largely free. The cross-couple formation however necessitates two gate spacer merge layer widths GI and a spacing GIP, as shown by the above cell height equation. This limits the ability to down-scale the bit cell height. This limit can be avoided by enabling part of the cross-couple formation at the bottom tier, which is largely empty, instead of only at the top tier. Therefore, as illustrated for the SRAM device 3 and the bit cell 30 in Fig. 7a-c, the cross-couple formation is segmented into its partially integrations in the bottom tier 30B and at the top tier 30T. Compared to the layout in Fig. 6a-c, this layout design, however, requires both a bottom cross-couple merge layer (bottom metal strap ) "XCB" and a top cross-couple merge layer (top metal strap) "XCT".

More specifically, the gate extension of the common gate of the first CFET device 31 of the first half-cell H1 (first common gate) and the contact extension of the second common S/D contact of the second half-cell H2 are arranged in the bottom device tier 30B but not the top device tier 30T. Meanwhile, the gate extension of the common gate of the first CFET device 33 (second common gate) of the second half-cell H2 and the contact extension of the first common S/D contact are arranged in the top device tier 30T but not the bottom device tier 30B.

Accordingly, the gate extension of the first common gate is comprised in the bottom gate portion GB and protrudes relative to the top gate portion GT of the first common gate. Correspondingly, the contact extension of the second common S/D contact is comprised in the bottom contact portion (in MOAB) of the second common S/D contact and protrudes relative to the top contact portion (in MOAT) of the second common S/D contact. On the other hand, the gate extension of the second common gate is comprised in the top gate portion GT of the second common gate and protrudes relative to the bottom gate portion GB of the second common gate. Correspondingly, the contact extension of the first common S/D contact is comprised in the top contact portion (in MOAT) of the first common S/D contact and protrudes relative to the bottom contact portion (in MOAB) of the first common S/D contact.

As shown, the respective contact extensions may protrude past the midline C of bit cell 30. The cross-couple merge layer / first metal strap XC for the cross-coupling in the bottom tier 30B may be comprised in the local interconnect layer M0A and arranged on top of the bottom tier local interconnect layer MOAB.

The cross-couple merge layer / second metal strap XC for the cross-coupling in the top tier 30T may be comprised in the local interconnect layer M0A and arranged on top of the top tier local interconnect layer MOAT.

Furthermore, in order to avoid direct influence on the cell height and facilitate process integration, the respective M0A merge layers M0AM of the first and second common S/D contacts and the gate merge layers GM of the common gates of the first CFET devices 21 and 23 have been shifted towards the cell edges, to be arranged outside of the area between the first and second active tracks A1, A2, as shown in Fig. 7a. These two changes, i.e., enabling cross-coupling separately on the top and bottom tiers and removing M0A MRG from between device, lead to a bit cell height of 114 nm:

$$\text{Cell height} = \text{GC} + 3*\text{GE} + 2*\text{NSHW} + \text{GI} + \text{GIP} + 3*\text{CD} + \text{M0A\_extn}$$
$$= 12 + 3*9 + 2*11 + 9 + 12 + 3*9 + 5 = 114 \text{ nm (eq. 2)}$$

which is 22 nm smaller than the layout design of Fig. 6a-c. The additional term M0A_extn (denoted ME in the figures) is the minimum extension of the S/D contacts in either MOAB or MOAT.

The dual-port 8T to single-port 6T ratio for the CFET NS-on-NS scheme bit cell design of Fig. 7a-c described above is 114 nm/97 nm (=1.18). To further scale the CFET dual-port 8T bit cell, the top nanosheets are in the bit cell 40 of SRMAM device 4 of Fig. 8a-c replaced by a Fin-NMOS device, to obtain first and second Fin-on-NS CFETs 41, 42, 43, 44 in each half-cell H1, H2. That is, the bottom devices of the CFET devices 41, 42, 43, 44 are configured as nanosheet-FETs and the top devices as finFETs.This enables a further reduction as will be explained in the following.

However, the Fin-on-NS bit cell height is insufficient for all of the routing tracks in the first interconnect level M0. Therefore, the second power rail VSS is shifted to the first interconnect level M0 and the bit lines of port A (BL-A and BLB-A) are configured as buried bit lines, arranged between the two instances of the first BPRs VDD as shown in cross-sectional view of Fig. 8b-c.

Accordingly, in contrast to the bit cell 30, the bit cell 40 is associated with only seven routing tracks of the first interconnect level M0. Like for the bit cell 30, a first and second instance of the first word line WL-A is arranged along first and second edge tracks. The second power rail VSS is arranged along a mid track (or center track). The second bit line BL-B and the second complementary bit line BLB-B are arranged in first and second off-center tracks, respectively, arranged on opposite sides of the mid track. The first and second instances of the second word line WL-B are arranged in third and fourth off-center tracks, respectively, the third off-center track being arranged between the first edge track and the first off-center track, and the fourth off-center track being arranged between the second edge track and the second off-center track.

Thus, inside the bit cells 30, 40, (i.e., between active tracks A1-A2), the dimensions of the layouts in Fig. 7a and 8a are essentially identical, and is disregarding the nanosheet width NSHW and the fin width FW it given by: GE + GC + GI + GIP + M0A_extn.

Towards the edges of the bit cell 30, the remaining dimension is calculated as 2*(NSHW + GE + CD + 0.5CD). The additional 0.5CD is introduced by the WL-A routing tracks in the first interconnect layer M0 layer of the WL which will be shared with the adjacent top and lower bit cells (not visible in Fig. 7a), which gives the cell height as calculated in eq. 2.

For the Fin-on-NS case of the bit cell 40, the cell height is governed by the layout design requirements of the top tier 40T only. This is because the gate extension GE required for the top Fin T-Fin begins at the edge of the fin (which is within the foot print of the bottom nanosheet B-NS) and extends over the bottom nanosheet B-NS. Consequently, the nanosheet width NSHW does not contribute to the cell height in this layout. Therefore, the remaining contribution to the cell height becomes 2*(FW + GE + CD + 0.5*GC), which gives a total cell height as:

$$\text{Cell height} = (\text{GE} + \text{GC} + \text{GI} + \text{GIP} + \text{M0A\_extn}) + 2*(\text{FW} + \text{GE} + \text{CD} +$$
$$0.5*\text{GC}) = 2*\text{GC} + 3*\text{GE} + 2*\text{FW} + \text{GI} + \text{GIP} + 2*\text{CD} + \text{M0A\_extn}$$
$$= 2*12 + 3*9 + 2*5 + 9 + 12 + 3*9 + 5 = 105 \text{ nm (eq.3)}$$

The 6T CFET bit cell height cannot be scaled by placing the Fin device on top. As a result, the bit cell footprint ratio of dual-port (8T) to single-port (6T) is 1.08, which is very close to 1 as the ratio that is theoretically possible in CFET device architecture.

The person skilled in the art realizes that the present invention by no means is limited to the embodiments described above. On the contrary, many modifications and variations are possible within the scope of the appended claims. For example, while in the illustrated examples, the PMOS devices are provided in the bottom tier and the NMOS devices are provided in the top tier, it is also possible to provide the NMOS devices in the bottom tier and the PMOS devices in the top tier. This may be done without any change to the inverter cross-coupling, but only some corresponding permutation of the power rails and routing tracks, for instance the configuration of the power rails VDD, VSS such that there are two instances of the pull-down power rail VSS and one instance of the pull-up power rail VDD. Additionally, while in the illustrated examples the CFET devices are of a configuration which may be obtained using e.g. the sequential CFET process. It is envisaged that analogous bit cell layouts may be achieved using a monolithic CFET process, supplemented with additional process steps forming split gates between the bottom and top pass gates.

**Claims**

1. A static random access memory, SRAM, device (1, 2, 3, 4) comprising:
   a plurality of bit cells (10, 20, 30, 40), each bit cell comprising a first half cell (H1) and a second half cell (H2), each half cell comprising:

   a first and a second complementary field-effect transistor, CFET, device, (21, 22, 23, 24) each CFET device comprising a bottom device (21B, 22B, 23B, 24B) and a top device (21T, 22T, 23T, 24T) stacked on top of the bottom device (21B, 22B, 23B, 24B),
   wherein the first CFET device (21, 23) comprises a common gate shared by the bottom device (21B, 23B) and the top device (21T, 23T) and is configured as an inverter (PU-1, PD-1; PU-2, PD-2) cross-coupled to the inverter of the other half-cell (H2, H1),
   wherein the bottom device (22B, 24B) of the second CFET device (22, 24) is configured as a first pass-gate (PG1-A, PG2-A) for a first port of the half-cell (H1, H2) and comprises a bottom gate coupled to a first word line (WL-A), and
   wherein the top device (22T, 24T) of the second CFET device (22, 24) is configured as a second pass-gate (PG1-B, PG2-B) for a second port of the half-cell (H1, H2) and comprises a top gate which is separate from the bottom gate and is coupled to a second word line (WL-B).

2. The SRAM device of claim 1, wherein the common gate of the first CFET device (21) of the first half-cell (H1) and the bottom and top gates of the second CFET device (24) of the second half-cell (H2) are arranged along a first gate track (G1), and the common gate of the first CFET device (23) of the second half-cell (H2) and the bottom and top gates of the second CFET device (22) of the first half-cell (H1) are arranged along a second gate track (G2), the first and second gate tracks (G1, G2) being parallel to a cell height dimension (Y) of the bit cell (10, 20), and
   wherein each CFET device (21, 22, 23, 24) comprises a first and second S/D region, wherein the S/D regions of the CFET devices (21, 22) of the first half-cell (H1) are arranged along a first active track (A1), and the S/D regions of the CFET devices (23, 24) of the second half-cell (H2) are arranged along a second active track (A2), the first and second active tracks (A1, A2) being parallel to a cell width dimension (X) of the bit cell (10, 20) and transverse to the cell height dimension (Y).

3. The SRAM device of claim 2, wherein the first half-cell (H1) comprises a first common S/D contact arranged between and shared by the first and second CFET devices (21, 22; 31, 32) of the first half-cell (H1), and the second half-cell (H2) comprises a second common S/D contact arranged between and shared by the first and second CFET devices (23, 24; 33, 34) of the second half-cell (H2),

   wherein the common S/D contact of the first and second half-cell each comprise a contact extension protruding towards the common S/D contact of the other half-cell (H1, H2),
   wherein the common gates of the first CFET devices (21, 23; 31, 33) of the first and second half-cells (H1, H2) define first and second common gates, respectively, wherein the first and second common gates each comprise a gate extension protruding towards the second CFET device (22, 24; 32, 34) of the other half-cell (H1, H2),
   wherein the bit cell (20; 30) comprises:

   a first local cross-coupling interconnect extending between and interconnecting respective tip portions of the gate extension of the first common gate and the contact extension of the second common S/D contact, and
   a second local cross-coupling interconnect extending between and interconnecting respective tip portions of the gate extension of the second common gate and the contact extension of the first common S/D contact.

4. The SRAM device of claim 3, wherein the tip portion of the gate extension of the first common gate is separated from a tip portion of the bottom and top gates of the second CFET device (24) of the second half-cell (H2) by a first gate cut region (GC), and wherein the tip portion of the gate extension of the second common gate is separated from a tip portion of the bottom and top gates of the second CFET device (22) of the first half-cell (H1) by a second gate cut region (GC).

5. The SRAM device of any one of claims 3-4, wherein the first and second local cross-coupling interconnect is configured as a first and second metal strap, respectively, extending along the cell width dimension (X) to bridge a distance between the respective tip portions.

6. The SRAM device of claim 5, wherein the first and second metal straps are arranged on top of the respective tip portions.

7. The SRAM device of any one of claims 5-6, wherein the bottom devices (31B, 32B, 33B, 34B) are arranged in a bottom device tier (30B) of the bit cell (30) and the top devices (31T, 32T, 33T, 34T) are arranged in a top device tier (30T) of the bit cell (30),

   wherein the gate extension of the first common gate and the contact extension of the second common S/D contact are arranged in the bottom device tier (30B) but not the top device tier (30T), and
   wherein the gate extension of the second common gate and the contact extension of the first common S/D contact are arranged in the top device tier (30T) but not the bottom device tier (30B).

8. The SRAM device of claim 7, wherein the contact extensions protrude at least to a midline (C) of bit cell (30).

9. The SRAM device of any one of claims 7-8, wherein each bottom device (41B, 42B, 43B, 44B) is a nanosheet-FET device and each top device (41T, 42T, 43T, 44T) is a finFET device comprising a channel structure with a width dimension smaller than a width dimension of a channel structure of each nanosheet-FET device.

10. The SRAM device of any one of claims 5-6, wherein the bottom devices (21B, 22B, 23B, 24B) are arranged in a bottom device tier (20B) of the bit cell (20) and the top devices (21T, 22T, 23T, 24T) are arranged in a top device tier (20T) of the bit cell (20),
    wherein the gate extensions of the first and second common gates and the contact extensions of the first and second common S/D contacts are arranged in at least the top device tier (20T).

11. The SRAM device of any one of the preceding claims,

    wherein the first and second pass-gates (PG1-A, PG1-B) of the first half-cell (H1) are coupled to a first and second bit line (BL-A, BL-B), respectively,
    wherein the first and second pass-gates (PG2-A, PG2-B) of the second half-cell (H2) are coupled to a first and second complementary bit line (BLB-A, BLB-B), and
    wherein the inverters of the first and second half-cells are coupled to a first power rail (VDD) and second power rail (VSS), one providing a pull-up voltage and the other providing a pull-down voltage.

12. The SRAM device of claim 11, when dependent on claim 2,

    wherein the inverter of the first half-cell (H1) is coupled to a first instance of the first power rail (VDD) and the inverter of the second half-cell (H2) is coupled to a second instance of the first power rail (VDD), wherein the first and second instances of the first power rail (VDD) are configured as a respective buried power rail extending along a bottom and top edge of the respective bit cell (20, 30, 40), and
    wherein the inverters of the first and second half-cells (H1, H2) are coupled to a same instance of the second power rail (VSS), wherein the instance of the second power rail (VSS) is configured as a buried power rail extending along a midline of the respective bit cell (20, 30) or as a metal line arranged in a routing track of an interconnect level above the bit cell (40).

13. The SRAM device of claim 12, when further dependent on claim 9, wherein the instance of the second power rail (VSS) is configured as a metal line arranged in a routing track of an interconnect level above the bit cell (40), and the first bit line (BL-A) and the first complementary bit line (BLB-A) are configured as buried signal lines, arranged between the first and second instances of the first power rail.

14. The SRAM device of claim 13, wherein the routing track is a mid track of a set of routing tracks of the interconnect level and associated with the bit cell (40), the set of routing tracks extending along the cell width dimension (X) and further comprising: first and second edge tracks overlapping a top and bottom edge of the bit cell, respectively, a first and second off-center track arranged on opposite sides of the mid track, a third off-center track arranged between the first off-center track and the first edge track, and a fourth off-center track arranged between the second off-center track and the second edge track,

wherein first and second instances of the first word line (WL-A) are arranged in the first and second edge tracks, respectively,

first and second instances of the second word line (WL-B) are arranged in the third and fourth off-center tracks, respectively, and

the second bit line (BL-B) and the second complementary bit line (BLB-B) are arranged in the first and second off-center tracks, respectively.

15. The SRAM device of any one of the preceding claims, wherein the bottom device (21B, 22B, 23B, 24B) of each CFET (21, 22, 23, 24) is a PMOS device and the top device (21T, 22T, 23T, 24T) of each CFET (21, 22, 23, 24) is an NMOS device, or vice versa.

*Fig. 1*

*Fig. 2*

*Fig. 3*

**Fig. 4**

100a

GV    GV    CD    GV
124
120
123

110
114
113

Z
Y

***Fig. 5a***

100b

CV    CV
125
120
121

110
115
111

VBPR
BPR

Z
Y

***Fig. 5b***

100c

104    GV
124
120

GM
110
114

Z
Y

***Fig. 5c***

100d

105    CV
125
120
121

M0AM
110
115
111

Z
Y

***Fig. 5d***

100e

104'    GV
124'
120
114'

110

Z
Y

***Fig. 5e***

100f

105'    CV
125'
120
121
115'
111

110

Z
Y

***Fig. 5f***

Fig. 6a

VDD

VSS

VDD

WL-A
BL-A
WL-B
BL-B
BLB-B
WL-B
BLB-A
WL-A

WL-A  WL-B

M0AB
M0AT
GV
CV
M0AM
GM
B-NS
T-NS
XC
GB
GT
VBPR

A-A

20

22

WL-A | BL-A | WL-B | BL-B

22T
PG-1B

CD

22B
PG1-A

GE    GE

Z
Y

**Fig. 6b**

B-B

20

22

WL-A | BL-A | WL-B | BL-B

22T
PG-1B

22B
PG1-A

Z
Y

**Fig. 6c**

EP 4 576 217 A1

Fig. 7a

EP 4 576 217 A1

EP 4 576 217 A1

A-A

30

32

WL-A

BL-A

WL-B

BL-B

CD

32T
PG-1B

32B
PG1-A

GE   GE

Z

Y

**Fig. 7b**

B-B

30

32

WL-A

BL-A

WL-B

BL-B

32T
PG-1B

32B
PG1-A

Z

Y

**Fig. 7c**

Fig. 8a

**Fig. 8b**

**Fig. 8c**

EP 4 576 217 A1

Europäisches
Patentamt

European
Patent Office

Office européen
des brevets

# EUROPEAN SEARCH REPORT

**Application Number**

EP 23 21 9670

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YOU WEI-XIANG ET AL: "Write-enhanced Single-ended 11T SRAM Enabling Single Bitcell Reconfigurable Compute-in-Memory Employing Complementary FETs", 2023 IEEE SYMPOSIUM ON VLSI TECHNOLOGY AND CIRCUITS, 11 June 2023 (2023-06-11), pages 1-2, XP034383324, DOI: 10.23919/VLSITECHNOLOGYANDCIR57934.2023.10185283 | 1,11,15 | INV. H01L27/02 H01L27/06 H01L27/092 H10B10/00 |
| Y | * page 1, left-hand column; figures 1,3 * | 2-10 | |
| A | | 12-14 | |
| | ----- | | |
| X | US 2021/043630 A1 (LIEBMANN LARS [US] ET AL) 11 February 2021 (2021-02-11) * paragraphs [0033] - [0080], [0091]; figures 1A, 1B, 3A, 3B, 3L * | 1,15 | |
| | ----- | | |
| X | US 2022/102362 A1 (CHANEMOUGAME DANIEL [US] ET AL) 31 March 2022 (2022-03-31) | 1,12-15 | |
| Y | * figures 4C, 8L * | 2-10 | TECHNICAL FIELDS SEARCHED (IPC) |
| | ----- | | H01L |
| A | US 2022/108742 A1 (LI XIA [US] ET AL) 7 April 2022 (2022-04-07) * figure 2A * | 12-14 | G11C H10B |
| | ----- | | |
| Y | LIU HSIAO-HSUAN ET AL: "DTCO of sequential and monolithic CFET SRAM", PROC. OF SPIE, vol. 12495, 28 April 2023 (2023-04-28), pages 124950Z1-124950Z7, XP060179981, ISSN: 0277-786X, DOI: 10.1117/12.2657524 ISBN: 978-1-5106-6097-7 * figures 4-7 * | 2-10 | |
| | ----- | | |
| Y | US 2021/313326 A1 (LIM KWANYONG [US] ET AL) 7 October 2021 (2021-10-07) * figure 1A * | 9 | |
| | ----- | | |

The present search report has been drawn up for all claims

| Place of search | Date of completion of the search | Examiner |
|---|---|---|
| Munich | 17 June 2024 | Mosig, Karsten |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 9670

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2024

| Patent document cited in search report | Publication date | Patent family member(s) | Publication date |
|---|---|---|---|
| US 2021043630 A1 | 11-02-2021 | CN 114175248 A | 11-03-2022 |
| | | JP 2022543116 A | 07-10-2022 |
| | | KR 20220042421 A | 05-04-2022 |
| | | TW 202121652 A | 01-06-2021 |
| | | US 2021043630 A1 | 11-02-2021 |
| | | WO 2021025797 A1 | 11-02-2021 |
| US 2022102362 A1 | 31-03-2022 | KR 20230074471 A | 30-05-2023 |
| | | TW 202234402 A | 01-09-2022 |
| | | US 2022102362 A1 | 31-03-2022 |
| | | WO 2022072033 A1 | 07-04-2022 |
| US 2022108742 A1 | 07-04-2022 | NONE | |
| US 2021313326 A1 | 07-10-2021 | NONE | |

EPO FORM P0459

For more details about this annex : see Official Journal of the European Patent Office, No. 12/82